# EUROPEAN PATENT APPLICATION

(11) **EP 1 437 931 A2**
(43) Date of publication of application: **14.07.2004**
(21) Application number: 03258089.6
(22) Date of filing: 20.12.2003
(51) Int. Cl.: H05K 7/14

(54) **Electronic units and connections**

(30) Priority: 11.01.2003 GB 0300616
(71) Applicant: Smiths Group PLC, London NW11 8DS (GB)
(72) Inventor: Dent, Peter, Enfield, Middlesex EN1 2RE (GB)
(74) Representative: Flint, Jonathan McNeill

(57) **Abstract**

An avionics housing has electrical connectors 21 to 24 mounted centrally on a front face 1. Transient voltage suppressors 29 are located in an array of holes 28 in a metal plate 20 to each side of the connectors, beneath removable panels 27 so that they are accessible on the front face after removal of the panels. The suppressors 29 extend through the plate 20 to connect with circuit boards 35 and 36 on the opposite side that have tracks connecting with the connectors 21 to 24. A filter module 12 is secured behind the circuit boards 35 and 36 and supports filters that connect with connections on the boards 35 and 36. A rear connection assembly 13 carries connectors 41 to 44 on its rear surface by which connection is made to circuits 9 within the unit. Flexi-rigid circuits 61 to 66 interconnect the rear connectors 41 to 44 with socket array boards 51 to 56 on the front of the rear connection assembly and these, in turn, connect with contacts on the filter module 12.

## Description

This invention relates to electronic units of the kind including an outer housing, electronics components within the housing and an electrical connector on a face of the outer housing making electrical connection with the components within the housing.

The invention is more particularly concerned with units, such as avionics ARINC units, containing electronic circuits and components within a housing on which is mounted an electrical connector by which electrical connection is made to and from the unit.

In order to protect the circuits and components within the unit from transient voltages such as caused by lightning strikes or the like, it is common practice for the connector to have associated with it suppression devices such as diodes that conduct the transient voltage to ground. Connectors may have several hundred contacts each of which have to be individually connected to ground via a TVS (transient voltage suppressor). Where the TVSs are mounted within the unit itself replacement is a problem because the unit has to be opened and retested in an approved manner after sealing closed. Alternatively, the TVS devices can be mounted directly on the contacts, which are constructed so that they can be removed individually from the front of the connector. The problem with this approach is that the TVS devices must be of a special construction in order to be mounted on the contacts, which may make them more expensive and less reliable than conventional devices.

It is an object of the present invention to provide an alternative electronics unit.

According to the present invention there is provided an electronics unit of the above-specified kind, characterised in that a plurality of electrical devices are connected between the connector and the housing and that the devices are located on the face to one side of the connector and are accessible without removal of the connector.

The devices may be transient voltage suppressors and are preferably located in individual holes in a metal plate. The devices may be located beneath a removable panel on the face. The devices and the contacts of the connector are preferably mounted on a support plate to be accessible on a front surface of the plate, the devices and contacts each extending through the plate and having contacts exposed on a rear surface of the support plate. The unit may include one or more circuit boards having contacts located on a forward surface arranged to make electrical contact with respective ones of the contacts exposed on the rear surface of the support plate. The circuit boards are preferably arranged electrically to interconnect the devices with the contacts of the connectors. The unit may include a filter module including a plate supporting an array of filters arranged in the same configuration as the contacts of the connector. The filters each may have a contact on the front surface of the filter plate and a contact on the rear surface of the filter plate. The unit preferably includes a rear connector assembly including a support plate having one or more connectors mounted on a rear surface, one or more socket array boards mounted on a forward surface of the plate and one or more flexi-rigid circuits extending around one or more edges of the plate to interconnect the connectors on the rear surface with the socket array boards on the forward surface.

An avionics unit according to the present invention will now be described, by way of example, with reference to the accompanying drawings, in which:
- Figure 1: is a perspective view of the unit from the front with its casing moved rearwardly by a small distance;
- Figure 2: is a perspective view of the front of the unit with a panel removed from the front face;
- Figure 3: is an exploded perspective view of the rear side of a part of the front of the unit;
- Figure 4: is an exploded perspective view from the front showing the rear connector assembly separated rearwardly; and
- Figure 5: is an exploded perspective view of the front of the unit from the rear showing the rear connector assembly separated rearwardly.

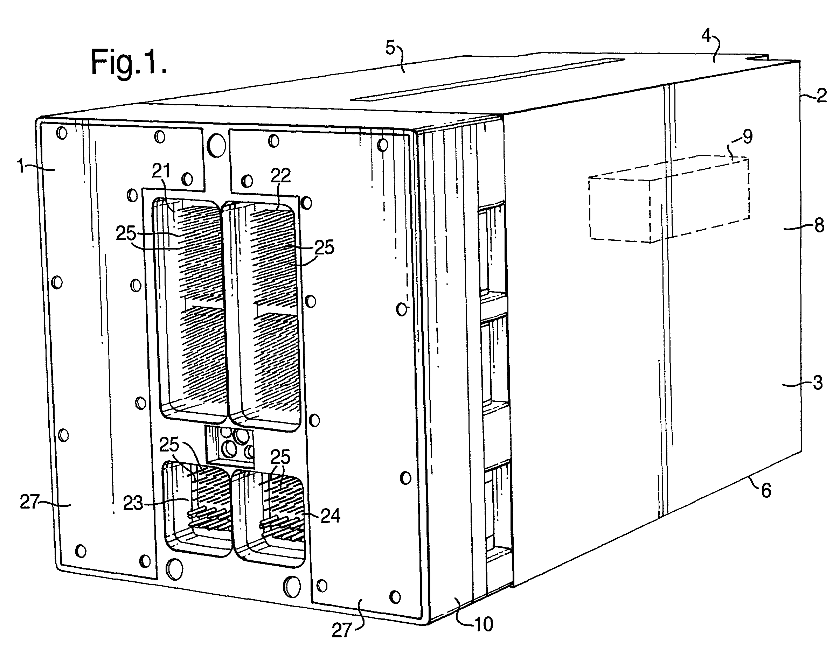

With reference first to Figure 1, the avionics unit is of a conventional size and shape with square front and rear faces 1 and 2, and rectangular side faces 3 to 6. The housing of the unit includes a sheet metal casing 8 slid rearwardly a short distance in Figure 1 to show the front sub-assembly 10 of the unit. The avionics unit contains conventional electronic circuits and components indicated generally by the numeral 9.

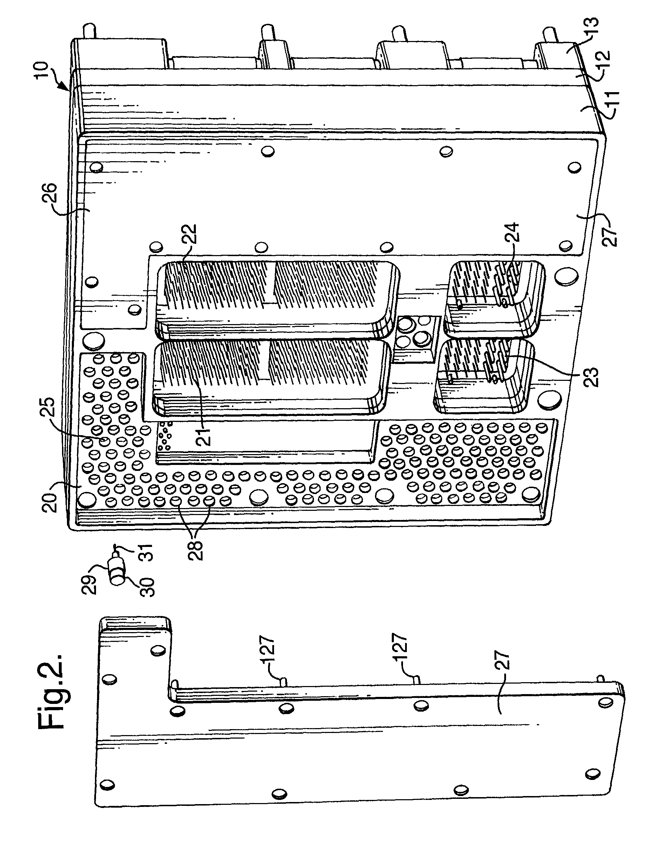

With reference now also to Figures 2 to 5, the sub-assembly 10 comprises a front connector assembly 11, a filter module 12 located behind the front assembly and a rear connector assembly 13 located behind the filter module.

The front connector assembly 11 includes an aluminium support plate 20 supporting two rectangular electrical connectors 21 and 22 and two square connectors 23 and 24 recessed within the front face 1 and each having multiple contacts 25 accessible from the front face. The rectangular connectors 21 and 22 are located side-by-side above the square connectors 23 and 24. The connectors 21 to 24 are located midway across the width of the front face 1 and are bordered on opposite sides by respective L-shape recesses 25 and 26. The recesses 25 and 26 are covered by two cover plates 27 secured to the support plate 20 by screws 127. Gaskets (not shown) provide a seal between the cover plates 27 and the support plate 20. The recesses 25 and 26 have an array of holes 28 machined through the thickness of the support plate 20, one for each of the contacts 25 on the connectors 21 to 24. Each hole 28 mounts a respective TVS in the form of a diode 29 (Figure 2). The diodes 29 are of the form sold by Sabritec, Inc of Irvine, California and are of cylindrical shape with one electrode provided by a circumferential spring clip 30 and a second electrode provided by an axially extending pin 31. The diodes 29 are fitted within the holes 28 with their axial electrodes 31 extending rearwardly and with their spring clips 30 retaining the diodes in the support plate 20 and making electrical connection with the support plate and, via this, with ground.

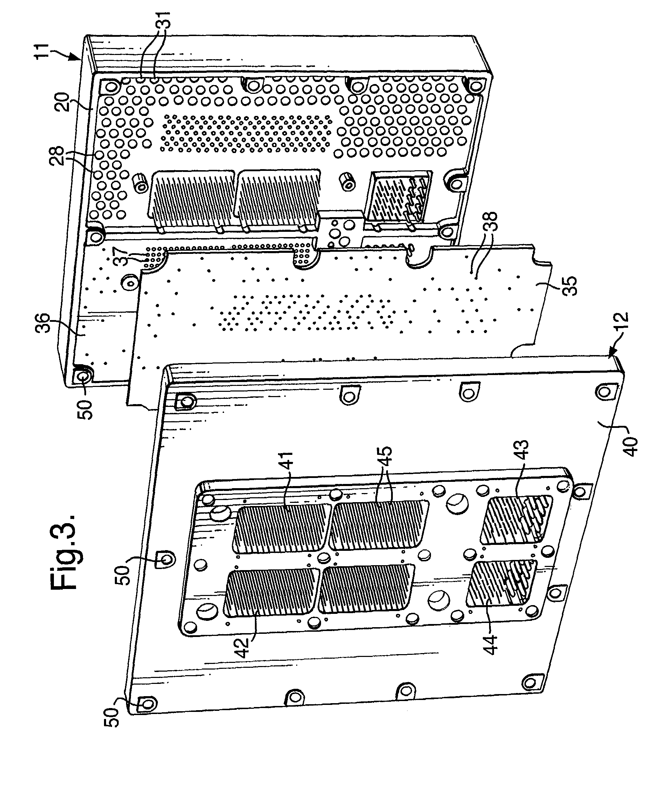

Figure 3 shows the pins 31 of the diodes 29 projecting from the rear side of the support plate 20, these pins being electrically isolated from the holes 28 in the plate. Electrical connection between the contacts 25 of the connectors 21 to 24 and respective ones of the pins 31 of the diodes 29 is made by two circuit boards 35 and 36, which overlay the connectors 21 and 23 and the connectors 22 and 24 respectively. The circuit boards 35 and 36 have a first array of holes 37 containing low profile contacts which make plug-in connection with the contacts 25. Similarly, a second array of holes 38 on the boards 35 and 36 contains low profile contacts which make connection with the diode pin electrodes 31. Conductive tracks (not shown) in the boards 35 and 36 interconnect respective ones of the connector contacts 25 with respective ones of the diodes 29 so that high voltage transients on any one of the contacts are conducted via a respective diode to ground.

The filter module 12 is secured to the rear of the front connector assembly 11 over the boards 35 and 36. The filter module 12 comprises an aluminium plate 40 supporting four connectors 41 to 44 corresponding to the connectors 21 to 24 on the front face 1 of the sub-assembly 10. The contact pins 45 of the connectors 41 to 44 include filters (not shown) of a conventional kind. In particular, the filter module 12 has a filter for each contact pin 45, the pins extending through apertures in two parallel capacitor array boards each of which is connected to ground. The filters are arranged in an array corresponding to the configuration of the contacts 25 of the connectors 21 to 24. Each pin 45 carries a ferrite bead acting as an inductor, between the capacitor array boards. Signals on the filter pins 45 within selected frequency ranges are conducted via the capacitor array boards to the plate 40 and to ground.

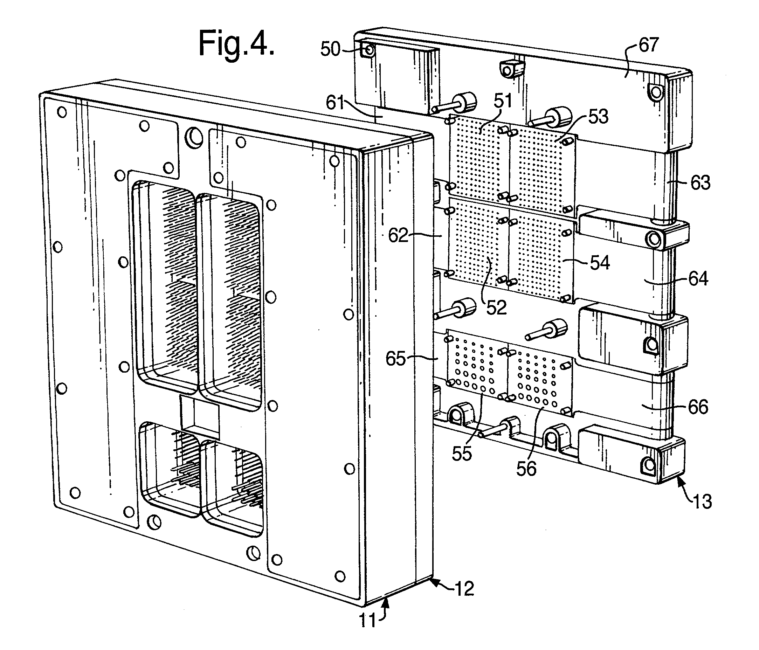

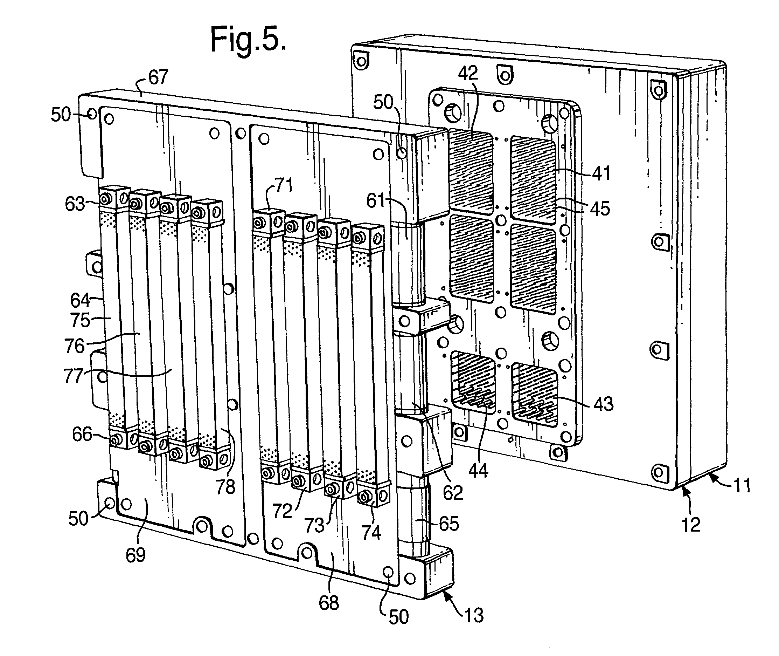

The sub-assembly 10 is completed by the rear connector assembly 13 (most clearly shown in Figures 4 and 5) secured with the filter module 12 and front connector assembly 11 by bolts (not shown) passing through holes 50 around the edge of the assemblies. The rear connector assembly 13 is electrically connected with the filter module 12 by plug-in connection of the contact pins 45 on the connectors 41 to 44. This is achieved by means of six, square socket array boards 51 to 56 carrying a socket 57 for making plug-in connection with respective contacts 45 on the connectors 41 to 44. Two of the boards 51 and 52 are aligned with upper and lower halves of the rectangular connector 41, another two boards 53 and 54 are aligned with the upper and lower halves of the other rectangular connector 42, and the remaining two boards 55 and 56 are aligned with the two square connectors 43 and 44 respectively. The socket boards 51 to 56 are mounted at one end of respective flexi-rigid circuit strips 61 to 66 extending laterally outwardly and wrapped around the edges of an aluminium support plate 67. The other end of the circuit strips 61, 62 and 65 are connected to a rectangular circuit board 68 attached to the rear surface of the support plate 67. Similarly, the circuit strips 63, 64 and 66 are connected to a rectangular circuit board 69. The circuit boards 68 and 69 each support four rectangular connectors 71 to 74 and 75 to 78 by which connection is made to the various circuits 9 within the avionics unit.

The arrangement of the present invention enables diodes to be removed and replaced from the front of the avionics unit without the need to open the avionics unit itself. The diodes used can be of a conventional kind that are readily available in a reliable form. Instead of diodes, the invention could be used to mount other electrical devices, such as, for example, filter devices. The invention is not confined to avionics units but could be used with other electronics units.

## Claims

1. An electronics unit including an outer housing, electronics components (9) within the housing and an electrical connector (21 to 24) on a face (1) of the outer housing making electrical connection with the components within the housing, **characterised in that** a plurality of electrical devices (29) are connected between the connector (21 to 24) and the housing and that the devices are located on the face (1) to one side of the connector and are accessible without removal of the connector.

2. An electronics unit according to Claim 1, **characterised in that** the devices are transient voltage suppressors (29).

3. An electronics unit according to Claim 1 or 2, **characterised in that** the devices (29) are each located in individual holes (28) in a metal plate (20).

4. An electronics unit according to any one of the preceding claims, **characterised in that** the devices (29) are located beneath a removable panel (27) on the face (1).

5. An electronics unit according to any one of the preceding claims, **characterised in that** the devices (29) and the contacts (25) of the connector (21 to 24) are mounted on a support plate (20) to be accessible on the front surface (1) of the plate, and that the devices (29) and contacts (25) each extend through the plate (20) and have contacts (31) exposed on a rear surface of the support plate (20).

6. An electronics unit according to Claim 5, **characterised in that** the unit includes one or more circuit boards (35, 36) having contacts located on a forward surface arranged to make electrical contact with respective ones of the contacts (31) exposed on the rear surface of the support plate (20).

7. An electronics unit according to Claim 6, **characterised in that** the circuit boards (35, 36) are arranged electrically to interconnect the devices (29) with the contacts (25) of the connectors (21 to 24).

8. An electronics unit according to any one of the preceding claims, **characterised in that** the unit includes a filter module (12) including a plate (40) supporting an array of filters arranged in the same configuration as the contacts (25) of the connector (21 to 24).

9. An electronics unit according to Claim 8, **characterised in that** the filters each have a contact on the front surface of the filter plate (40) and a contact (45) on the rear surface of the filter plate (40).

10. An electronics unit according to any one of the preceding claims, **characterised in that** the unit includes a rear connector assembly (13) including a support plate (67) having one or more connectors (71 to 78) mounted on a rear surface, one or more socket array boards (51 to 56) mounted on a forward surface of the plate (67) and one or more flexi-rigid circuits (61 to 66) extending around one or more edges of the plate (67) to interconnect the connectors (71 to 78) on the rear surface with the socket array boards (51 to 56) on the forward surface.
